# EUROPEAN PATENT APPLICATION

(11) **EP 1 796 141 A1**
(43) Date of publication of application: **13.06.2007**
(21) Application number: 05768946.5
(22) Date of filing: 08.08.2005
(51) Int. Cl.: H01L 21/027, G03F 7/20

(54) **METHOD FOR CONTROLLING EXPOSURE SYSTEM, EXPOSURE METHOD AND SYSTEM USING SAME, AND METHOD FOR MANUFACTURING DEVICE**

(30) Priority: 09.08.2004 JP 2004232086
(71) Applicant: NIKON CORPORATION, Tokyo 100-8331 (JP)
(72) Inventor: MATUNARI, Syuuiti, c/o NIKON CORPORATION, Tokyo 100-8331 (JP)
(74) Representative: HOFFMANN EITLE
(86) International application number: PCT/JP2005/014512
(87) International publication number: WO 2006/016551

(57) **Abstract**

The purpose is to provide an exposure apparatus control method that is able to maintain good characteristics of optical elements for a long period of time. The partial pressure of a deterioration causing gas, which is an oxidizing gas or a coating forming gas, is monitored by a mass spectrometry apparatus 87, and a deterioration suppressing gas from a gas supply apparatus 86 is appropriately introduced into a vacuum container 84 under the control of a control apparatus 90, so it is possible to maintain good optical characteristics of the optical elements that a projection optical system 70, etc. comprise for a long period of time. In addition, decreases in the reflectivity of the optical elements that the projection optical system 70, etc. comprise are monitored by a illumination intensity sensor 88, and deterioration suppressing gas from the gas supply apparatus 86 is appropriately introduced into the vacuum container 84 under the control of the control apparatus 90. Through this as well, it is possible to maintain good optical characteristics of the optical elements that the projection optical system 70, etc. comprise for a long period of time.

## Description

### Technical Field

The present invention relates to an exposure apparatus control method that forms a mask pattern image on a substrate, an exposure method and apparatus using the same, and a device manufacturing method that uses an exposure apparatus that performs exposure using ultraviolet rays or extreme ultraviolet rays.

### Background Art

In recent years, in conjunction with the miniaturization of semiconductor integrated circuits, due to the diffraction limits of light, exposure technology that uses ultraviolet rays has been developed to improve the achieved resolution of optical systems. In addition, exposure technology that uses, instead of ultraviolet rays, extreme ultraviolet rays of a shorter wavelength (for example, 11~14 nm) is also being developed (see Japanese Unexamined Patent Application Publication No. 2003-14893).

### Disclosure of the Invention

In the above type of exposure apparatus, in the case where an optical system for illumination or projection is used under ultraviolet rays or extreme ultraviolet rays, even if the environment where the relevant optical system is placed were an inert gas atmosphere or a vacuum, it would not be possible to completely eliminate oxygen, moisture content, organic substances, etc. from the vicinity of the optical elements that the optical system comprises. On the other hand, ultraviolet rays and extreme ultraviolet rays have a large amount of energy. In this case, an oxidation reaction is unfortunately caused due to the oxygen, moisture content and substances of the surfaces of the optical elements being irradiated by ultraviolet rays or extreme ultraviolet rays. In addition, due to organic substances and substances of the surfaces of the optical elements being irradiated by ultraviolet rays or extreme ultraviolet rays, optical chemical vapor deposition (optical CVD) is caused, and a carbon film is unfortunately generated on the surface of the optical element. Due to these phenomena, the transmission characteristics and the reflection characteristics of optical elements unfortunately deteriorate, and problems such as the lifespan of the optical system becoming shorter occur.

Therefore, the purpose of the present invention is to provide an exposure apparatus control method that is able to maintain good characteristics of optical elements for a long period of time.

In addition, the purpose of the present invention is to provide an exposure method and exposure apparatus that use the above control method that is able to maintain good characteristics of optical elements for a long period of time as well as a device manufacturing method that uses the exposure apparatus.

To resolve the above issues, the exposure apparatus control method according to the invention comprises a step of monitoring an observation element that reflects at least one of causes and indications of deterioration relating to the optical system of the exposure apparatus and a step of introducing into a container a deterioration suppressing gas that includes at least one of a reducing gas, an oxidizing gas and a fluorinating gas according to the results of monitoring the observation element.

In the above control method, a deterioration suppressing gas that includes at least one of a reducing gas, an oxidizing gas and a fluorinating gas is introduced into the container according to the results of monitoring the observation element, so it is possible to use the deterioration suppressing gas to appropriately cancel out effects such as those of oxidation and carbon film growth on the surface of the optical element attributable to the presence of a deterioration causing gas such as oxygen. Therefore, it is possible to maintain good characteristics of optical elements and, in turn, an optical system for an exposure apparatus for a long period of time.

The first mode in which the above exposure apparatus control method has been embodied comprises a step of monitoring the partial pressure of a deterioration causing gas that includes at least one of oxygen, water and an organic substance in a container that accommodates an optical system of an exposure apparatus and a step of introducing a deterioration suppressing gas into a container according to the results of monitoring the deterioration causing gas so that the partial pressure of a deterioration suppressing gas that includes at least one of a reducing gas, an oxidizing gas and a fluorinating gas comes to have a ratio in a prescribed range with respect to the partial pressure of the deterioration causing gas in the container.

In the above control method, a deterioration suppressing gas is introduced into the container according to the results of monitoring the deterioration causing gas so that the partial pressure of the deterioration suppressing gas comes to have a ratio in a prescribed range with respect to the partial pressure of the deterioration causing gas in the container, so the deterioration suppressing gas can be used to appropriately cancel out the effects of oxidation and carbon film growth on the surface of the optical element that are due to a deterioration causing gas. In this case, it is possible to limit the possibility of the action of the deterioration suppressing gas becoming excessive and inflicting reverse damage on the optical element by setting the partial pressure ratio of the deterioration causing gas and the deterioration suppressing gas to a prescribed range. Therefore, it is possible to maintain good characteristics of optical elements and, in turn, an optical system for an exposure apparatus for a long period of time.

In a specific mode of the present invention, in the above control method, the deterioration causing gas is an oxidation deterioration gas that includes at least one of oxygen and water, and the deterioration suppressing gas is an oxidation inhibiting gas that includes at least one of a reducing gas and a fluorinating gas. In this case, in the presence of a high energy light beam, for example, it is possible to prevent the optical element from corroding from the surface due to an oxidation reaction, or it is possible to prevent an oxidation film that becomes a cause of deterioration of characteristics from being formed on the surface of the optical element, and it is possible to maintain good transmission characteristics and reflection characteristics of optical elements for a long period of time.

In another mode of the present invention, the ratio in a prescribed range relating to the oxidation inhibiting gases as the deterioration suppressing gases is from 1 × 10⁻⁷ to 1 × 10⁴. In this case, an upper limit ratio, 1 × 10⁴, for these oxidation inhibiting gases has been determined so that the bad effects resulting from the reducing gas or fluorinating gas atmosphere are suppressed while maintaining safe and reliable operation of the vacuum pump for exhaust, and a lower limit ratio, 1 × 10⁻⁷, for the oxidation inhibiting gases has been determined in consideration of ensuring the effects resulting from the oxidation inhibiting gases and of the lower limit of the sensitivity of the sensor for monitoring.

In yet another mode of the present invention, the deterioration causing gas is a coating forming gas that includes an organic substance, and the deterioration suppressing gas is a coating removing gas that includes at least one of a reducing gas, an oxidizing gas and a fluorinating gas. In this case, in the presence of a high energy light beam, for example, it is possible to prevent a carbon film from being produced on the surface of the optical element and light absorption from occurring by means of optical CVD of the organic substance, and it is possible to maintain good transmission characteristics and reflection characteristics of the optical elements for a long period of time.

In yet another mode of the present invention, the ratio in a prescribed range relating to the coating removing gases as the deterioration suppressing gases is from 1 × 10⁻² to 1 × 10⁸. In this case, an upper limit ratio, 1 × 10⁸, for these coating removing gases has been determined so that the bad effects resulting from the reducing gas, oxidizing gas or fluorinating gas atmosphere are suppressed while maintaining safe and reliable operation of the vacuum pump for exhaust, and a lower limit ratio, 1 × 10⁻², for the coating removing gases has been determined in consideration of ensuring the effects resulting from the coating removing gases and of the lower limit of the sensitivity of the sensor for monitoring.

The second mode that embodies the exposure apparatus control method according to the present invention comprises a step of monitoring the spectral characteristics of at least one optical element that comprises the optical system of an exposure apparatus and a step of introducing a deterioration suppressing gas that includes at least one of a reducing gas, an oxidizing gas and a fluorinating gas into a container that accommodates at least one optical element according to the results of monitoring of the spectral characteristics of at least one optical element. Here, the "spectral characteristics" of the optical element refer to optical characteristics such as the transmittivity, the reflectivity, etc. of the optical element in the wavelength range of the exposure light.

In the above control method, a deterioration suppressing gas that includes at least one of a reducing gas, an oxidizing gas and a fluorinating gas is introduced according to the results of monitoring of the spectral characteristics of at least one optical element, so it is possible to use the deterioration suppressing gas to appropriately cancel out effects such as those of oxidation of the surface of the optical element attributable to the presence of a deterioration causing gas such as oxygen. Therefore, it is possible to maintain good characteristics of optical elements and, in turn, an optical system for an exposure apparatus for a long period of time.

In a specific mode of the present invention, in the above control method, the optical system accommodated in the container is used in at least one wavelength range from among ultraviolet rays and extreme ultraviolet rays. In this case, an exposure environment results in which oxidation or carbon film generation are likely to occur on the surface of the optical element, but a deterioration suppressing gas is introduced at the appropriate timing in the manner discussed above, so, regardless of the relevant exposure environment, it is possible to maintain good characteristics of an exposure apparatus optical system for a long period of time.

The first exposure method according to the invention is an exposure method for forming a mask pattern image on a substrate and comprises a step for monitoring the partial pressure of a deterioration causing gas that includes at least one of oxygen, water and an organic substance in a container that accommodates an optical system for exposure and a step of introducing a deterioration suppressing gas into the container according to the results of monitoring the deterioration causing gas so that the partial pressure of the deterioration suppressing gas that includes at least one of a reducing gas, an oxidizing gas and a fluorinating gas comes to have a ratio in a prescribed range with respect to the partial pressure of the deterioration causing gas in the container. Note that the timing of introducing the deterioration suppressing gas into the container may be set to within an interval of or during suspension of exposure processing or during exposure processing.

In the above exposure method, the deterioration suppressing gas is introduced into the container according to the results of monitoring the deterioration causing gas so that the partial pressure of the deterioration suppressing gas comes to have a ratio in a prescribed range with respect to the partial pressure of the deterioration causing gas, so the deterioration suppressing gas can be used to appropriately cancel out the effects of oxidation and carbon film growth on the surface of the optical element attributable to deterioration causing gas. Therefore, it is possible to maintain good characteristics of optical elements and, in turn, an optical system for an exposure apparatus for a long period of time.

The second exposure method according to the invention is an exposure method for forming a mask pattern image on a substrate and comprises a step of monitoring the spectral characteristics of at least one optical element that an optical system for exposure comprises and a step of introducing a deterioration suppressing gas that includes at least one of a reducing gas, an oxidizing gas and a fluorinating gas into a container that accommodates at least one optical element according to the results of monitoring the spectral characteristics of at least one optical element.

In the above exposure method, a deterioration suppressing gas that includes at least one of a reducing gas, an oxidizing gas and a fluorinating gas is introduced according to the results of monitoring the spectral characteristics of at least one optical element, so it is possible to use the deterioration suppressing gas to appropriately cancel out effects such as those of oxidation of the surface of the optical element attributable to the presence of a deterioration causing gas such as oxygen. Therefore, it is possible to maintain good characteristics of optical elements and, in turn, an optical system for an exposure apparatus for a long period of time.

The first exposure apparatus according to the invention comprises a light source that generates light source light in a wavelength range of at least one of ultraviolet rays and extreme ultraviolet rays, an illumination optical system that guides light source light from the light source to a mask for transfer, a projection optical system that forms the pattern image of a mask on a substrate, a sensor that monitors the partial pressure of a deterioration causing gas that includes at least one of oxygen, water and an organic substance in a container that accommodates at least some optical elements from among a mask, an illumination optical system, and a projection optical system, a gas introduction apparatus that introduces a deterioration suppressing gas that includes at least one of a reducing gas, an oxidizing gas and a fluorinating gas into a container, and a control apparatus that sets the partial pressure of the deterioration suppressing gas to a ratio in a prescribed range with respect to the partial pressure of the deterioration causing gas in the container.

In the above exposure apparatus, the control apparatus sets the partial pressure of the deterioration suppressing gas to a ratio in a prescribed range with respect to the partial pressure of the deterioration causing gas in the container by controlling the operation of the gas introduction apparatus according to the results of monitoring the deterioration causing gas, so it is possible to use the deterioration suppressing gas to appropriately suppress and cancel out the effects of oxidation and carbon film growth on the surface of the optical element that are due to the deterioration causing gas. Therefore, it is possible to maintain good characteristics of optical elements and, in turn, performance of an exposure apparatus for a long period of time.

In a specific mode of the present invention, in the above first exposure apparatus, the deterioration causing gas is an oxidation deterioration gas that includes at least one of oxygen and water, and the deterioration suppressing gas is an oxidation inhibiting gas that includes at least one of a reducing gas and a fluorinating gas.

In another mode of the present invention, the deterioration causing gas is a coating forming gas that includes an organic substance, and the deterioration suppressing gas is a coating removing gas that includes at least one of a reducing gas, an oxidizing gas and a fluorinating gas.

The second exposure apparatus according to the present invention comprises a light source that generates light source light in a wavelength range of at least one of ultraviolet rays and extreme ultraviolet rays, an illumination optical system that guides light source light from the light source to a mask for transfer, a projection optical system that forms the pattern image of a mask on a substrate, a sensor that monitors the spectral characteristics of at least one optical element from among at least some optical elements that are accommodated in the container and that a mask, an illumination optical system, and a projection optical system comprise, a gas introduction apparatus that introduces a deterioration suppressing gas that includes at least one of a reducing gas, an oxidizing gas and a fluorinating gas into a container, and a control apparatus that controls the operation of the gas introduction apparatus according to the results of monitoring the spectral characteristics of at least one optical element.

In the above exposure apparatus, the control apparatus controls the operation of the gas introduction apparatus according to the results of monitoring the spectral characteristics of at least one optical element, so it is possible to use the deterioration suppressing gas to appropriately cancel out effects such as those of oxidation of the surface of the optical element attributable to the presence of a deterioration causing gas such as oxygen. Therefore, it is possible to maintain good characteristics of optical elements and, in turn, an optical system for an exposure apparatus for a long period of time.

In addition, according to the device manufacturing method of the present invention, it is possible to manufacture a high performance device by using the above exposure apparatus.

### Brief Description of the Drawings

FIG. 1 FIG. 1 is a block diagram for explaining a projection exposure apparatus according to an embodiment of the present invention.
FIG. 2 FIG. 2 is a flow chart that shows an example of a semiconductor device manufacturing process.

### Best Modes for Carrying Out the Invention

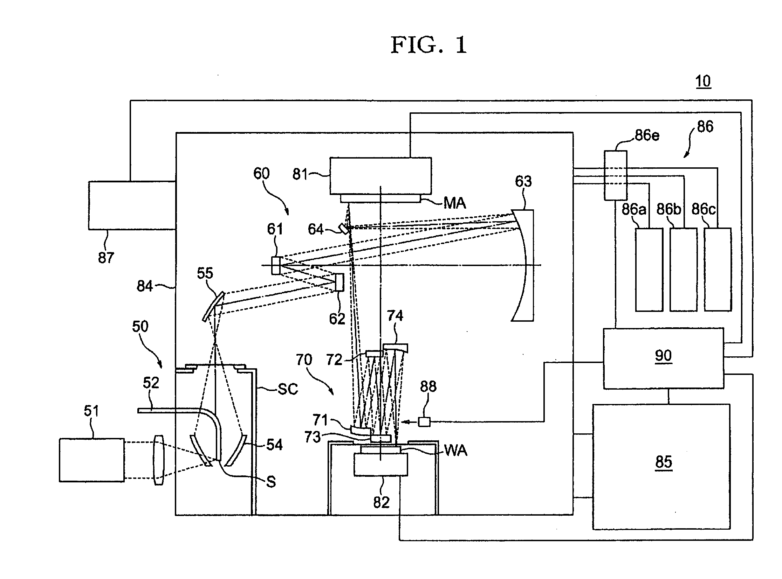

FIG. 1 is a drawing for explaining the structure of the exposure apparatus that is an embodiment of the present invention. This exposure apparatus 10 comprises a light source apparatus 50, which generates extreme ultraviolet rays (wavelength 11 ~ 14 nm), an illumination optical system 60, which illuminates a mask MA by the illumination light of the extreme ultraviolet rays, and a projection optical system 70, which transfers the pattern image of the mask MA to a wafer WA that is the substrate, and, for the mechanical mechanisms, it comprises a mask stage 81 that supports the mask MA and a wafer stage 82 that supports the wafer WA. In addition, the exposure apparatus 10 comprises a vacuum container 84 that accommodates part of the above light source apparatus 50 and the optical systems 60, 70, an exhaust apparatus 85 that exhausts the gas in the vacuum container 84, the gas supply apparatus 86 that is the gas introduction apparatus for introducing the deterioration suppressing gas into a vacuum container 84, a mass spectrometry apparatus 87 for monitoring the partial pressure of a specific gas in the vacuum container 84, and an illumination intensity sensor 88 that checks decreases in the reflectivity of specific optical elements that the projection optical system 70 comprise, for example. Moreover, the exposure apparatus 10 comprises a control apparatus 90 that comprehensively controls the operations of the respective parts of the exposure apparatus 10, specifically, the light source apparatus 50, the mask stage 81, the wafer stage 82, the exhaust apparatus 85, the gas supply apparatus 86, and the mass spectrometry apparatus 87.

The light source apparatus 50 comprises a laser light source 51 that generates laser light for plasma excitation and a tube 52 that supplies gas such as xenon, which is the target material, into a housing SC. In addition, a condenser 54 and a collimator mirror 55 are attached to this light source apparatus 50. By focusing the laser light from the laser light source 51 on the xenon emitted from the front end of the tube 52, the target material of that portion is converted into plasma to generate extreme ultraviolet rays. The condenser 54 converges the extreme ultraviolet rays generated at the front end S of the tube 52. The extreme ultraviolet rays that have passed through the condenser 54 exit to outside the housing SC while being converged and are incident to the collimator mirror 55. Note that it is possible to use, for example, irradiated light from a discharge plasma light source or an SOR (synchrocyclotron oscillation resonance) light source instead of light source light from a laser plasma type light source apparatus 50 such as the above.

The illumination optical system 60 comprises reflecting type optical integrators 61, 62, a condenser mirror 63, a folding mirror 64, etc. The light source light from the light source apparatus 50 is converged by the condenser mirror 63 while being made uniform as illumination light by the optical integrators 61, 62, and it is made incident to a prescribed region (for example, the strip-shaped region) on the mask MA via a folding mirror 64. Through this, it is possible to evenly illuminate the specified region on the mask MA by extreme ultraviolet rays of the appropriate wavelength.

Note that a substance that has adequate transmittivity in the wavelength range of extreme ultraviolet rays does not exist, and a reflection type mask is used as the mask MA rather than a transmission type mask.

The projection optical system 70 is a reduction projection system comprising a plurality of mirrors 71, 72, 73, 74. Image formation onto a wafer WA that has been coated with a resist is performed by the projection optical system 70, and the circuit pattern that is the pattern image formed on the mask MA is transferred to this resist. In this case, the region to which a circuit pattern is projected at once is a linear or arc-shaped slit region, and, for example, it is possible to transfer a rectangular circuit pattern formed on the mask MA to a rectangular region on the wafer WA effectively by means of scanning exposure that synchronously moves the mask MA and the wafer WA, for example.

The mask stage 81, under the control of the control apparatus 90, is able to move the mask MA to the desired position while supporting it and while precisely monitoring the position, velocity, etc. of the mask MA. In addition, the wafer stage 82, under the control of the control apparatus 90, is able to move the wafer WA to the desired position while supporting it and while precisely monitoring the position, velocity, etc. of the wafer WA.

The portion of the above optical apparatus 50 that is arranged on the optical path of the extreme ultraviolet rays, the illumination optical system 60, and the projection optical system 70 are arranged inside a vacuum container 84, and attenuation of the exposure light is prevented. Specifically, extreme ultraviolet rays are absorbed into the atmosphere and attenuated, but attenuation of extreme ultraviolet rays, that is, decreases in the brightness and decreases in the contrast of the transferred image, are prevented by maintaining the optical path of the extreme ultraviolet rays to a prescribed vacuum level (for example, 1.3 × 10⁻³ Pa or less) while shielding the entire apparatus from the exterior by means of the vacuum container 84.

The optical elements 54, 55, 61, 62, 63, 64, 71, 72, 73, 74 and the mask MA arranged on the optical path of the extreme ultraviolet rays inside the vacuum container 84 are such as a reflecting film formed on a base material made of silica glass, for example, which is the substrate. The reflecting film is a multilayer film of several layers to several hundred layers formed by, for example, alternately laminating thin film layers consisting of two or more substances whose refractive indices with respect to a vacuum differ onto a substrate. It is possible to use, for example, an Mo layer and a Si layer as the two or more types of thin film layers that this multilayer film comprises.

The exhaust apparatus 85 has a vacuum pump connected to a vacuum container 84, and the interior of the vacuum container 84 is maintained to the required vacuum level based on control by the control apparatus 90. On the other hand, a gas supply apparatus 86 has a gas source 86a for reducing gas, a gas source 86b for oxidizing gas, a gas source 86c for fluorinating gas, and a mass flow controller 86e that regulates the gas flow volume of these. The gas supply apparatus 86 supplies only the required amount of deterioration suppressing gas, which is reducing gas, oxidizing gas or fluorinating gas to the inside of the vacuum container 84 at the appropriate timing via introduction pipes based on control by the control apparatus 90. Through this, it is possible to regulate the partial pressure of the reducing gas, oxidizing gas, or fluorinating gas inside the vacuum container 84 to the target volume, and, in turn, it is possible to suppress the oxidation and carbon growth on the surfaces of optical elements 54, 55, 61, 62, 63, 64, 71, 72, 73, 74, etc. Note that the mass flow controller 86e may be replaced with a device in which a leak valve to which a drive apparatus such as a motor has been added is combined with a mass flow meter, a pressure regulator, etc.

A mass spectrometry apparatus 87 comprises, for example, a quadripolar mass spectrometer, and it functions as a partial pressure sensor for detecting, from the mass spectrum, the amount of molecules or atoms present in the vacuum container 84. This mass spectrometry apparatus 87 is able to detect the partial pressure of an oxidation deterioration gas, for example, oxygen or water, as the deterioration causing gas, and the measurement results of the partial pressure of such an oxidation deterioration gas are output to the control apparatus 90 always or at the appropriate timing. In addition, the mass spectrometry apparatus 87 is able to detect the partial pressure of the coating forming gas, such as an organic substance, and the measurement results of the partial pressure of such a coating forming gas are also output to the control apparatus 90 always or at the appropriate timing. At the time of detection of the coating forming gas, such as an organic substance, exhaustive detection of all of the organic substances is not practical, so, also taking into consideration the capability of the mass spectrometry apparatus 87, a technique that substitutes the sum total of the mass numbers within a range of mass numbers of 45 or more and less than 200 is convenient. Note that the quadripolar mass spectrometer noted above may be replaced with a bipolar mass spectrometer, etc.

Here, in the case where an oxidation deterioration gas such as oxygen, water, etc. is present as the atmospheric gas of optical element 54, 55, 61, 62, 63, 64, 71, 72, 73, 74, etc., when extreme ultraviolet rays are incident to such an optical element 54, 55, 61, 62, 63, 64, 71, 72, 73, 74, the multilayer film of the surface of the relevant optical element is gradually permeated due to an oxidation reaction, or an oxidation film is formed on the surface of the multilayer film, and the reflectivity of the optical element may be decreased over time. For this reason, the partial pressure of the oxidation deterioration gas is monitored based on the detection results of the mass spectrometry apparatus 87, and when the partial pressure of the oxidation deterioration gas has exceeded a fixed upper limit, the mass flow controller 86e that the gas supply apparatus 86 has is regulated to introduce a prescribed amount of deterioration suppressing gas (oxidation inhibiting gas) to the vacuum container 84 from the gas source 86a, 86c. One of the deterioration suppressing gases supplied from gas source 86a is a reducing gas, and, for example, hydrogen, ethanol, etc. is optimally used. The other deterioration suppressing gas supplied from gas source 86c is a fluorinating gas, and, for example, hydrogen fluoride, nitrogen fluoride, carbon fluoride, etc. is optimally used. The amount of deterioration suppressing gas introduced to the vacuum container 84 is at a level that is able to cancel out the effects of the oxidation deterioration gas based on the partial pressure of the oxidation deterioration gas and the reduction capability of the deterioration suppressing gas. For example, in the case where the partial pressure of the oxidation deterioration gas was returned to the maximum allowable limit or less, corrosion of the optical element by the oxidation deterioration gas and oxidation coating formation are considered to be stopped, so the introduction of deterioration suppressing gas is continued until the partial pressure of the oxidation deterioration gas has returned to an appropriate normal value at or below the above maximum limit. Other techniques are also conceivable. In the case where the partial pressure of the deterioration suppressing gas had markedly dropped from the immediate partial pressure following introduction, it would be considered that the oxidation deterioration gas was consumed by means of the deterioration suppressing gas. Specifically, it is also possible to continue introduction of the deterioration suppressing gas until there is no longer a decrease in the partial pressure of the deterioration suppressing gas. It is possible to set the start of the introduction of the deterioration suppressing gas to an appropriate timing after the partial pressure of the oxidation deterioration gas has increased to at or above a previously set value, but, at this time, it is also possible to set a status in which the light source apparatus 50 operates to irradiate extreme ultraviolet rays to the respective optical elements that the illumination optical system 60 and the projection optical system 70 comprise. In this case, the extreme ultraviolet rays perform the role of promoting an oxidation-reduction reaction and a fluorination reaction between the deterioration suppressing gas and the oxidation deterioration gas.

In a specific example of a reducing gas, in the case where introduction was performed so that the partial pressure of a deterioration suppressing gas, such as hydrogen and ethanol, was in a range of a ratio of 1 × 10⁻⁷to 1 × 10⁴ with respect to the partial pressure of an oxidation deterioration gas, such as oxygen and water, consumption of the oxidation deterioration gas was observed, and it was possible to avoid a decrease in the reflectivity of optical elements 54, 55, 61, 62, 63, 64, 71, 72, 73 and 74. The reaction equation below explains consumption of the oxidation deterioration gas (oxygen, moisture) by ethanol, which is the deterioration suppressing gas.
(Oxygen/moisture reduction)

3O₂+C₂H₅OH→2CO₂+3H₂O

3H₂O+C₂H₅OH→2CO₂+6H₂

In addition, in a specific example of a fluorinating gas, in the case where introduction was performed so that the partial pressure of a deterioration suppressing gas, such as hydrogen fluoride, nitrogen fluoride, and carbon fluoride, was in a range of a ratio of 1 × 10⁻⁷ to 1 × 10⁴ with respect to the partial pressure of an oxidation deterioration gas, such as oxygen and water, surface oxidation film growth suppression was observed, and it was possible to avoid a decrease in the reflectivity of optical elements 54, 55, 61, 62, 63, 64, 71, 72, 73 and 74. The reaction equation below explains decomposition of the oxidation film by hydrogen fluoride, nitrogen fluoride and carbon fluoride, which are the deterioration suppressing gases.
(Fluorination of oxidation film)

SiO₂+4HF→SiF₄+2H₂O

3SiO₂+4NF₃→3SiF₄+2N₂O₃

SiO₂+CF₄→SiF₄+CO₂

On the other hand, in the case where a coating forming gas such as an organic substance is present as the atmospheric gas of optical element 54, 55, 61, 62, 63, 64, 71, 72, 73, 74, etc., when extreme ultraviolet rays are incident to such an optical element, the organic substance is decomposed due to the optical CVD phenomenon, a carbon film is formed on the surface of the relevant optical element, and the reflectivity my be decreased over time. For this reason, the partial pressure of the coating forming gas is monitored based on the detection results of the mass spectrometry apparatus 87, and when the partial pressure of the coating forming gas has exceeded a fixed upper limit, the mass flow controller 86e that the gas supply apparatus 86 has is regulated to introduce an appropriate amount of deterioration suppressing gas (coating removing gas) to the vacuum container 84 from the gas source 86a, 86b, 86c. The deterioration suppressing gas supplied from gas source 86a is a reducing gas, and, for example, hydrogen, ethanol, etc. is optimally used as the deterioration suppressing gas supplied from gas source 86a. In addition, the deterioration suppressing gas supplied from gas source 86b is an oxidizing gas, and, for example, ozone, oxygen, nitrogen monoxide, sulfur dioxide, etc. is optimally used as the deterioration suppressing gas supplied from gas source 86b. In addition, the deterioration suppressing gas supplied from gas source 86c is a fluorinating gas, and, for example, hydrogen fluoride, nitrogen fluoride, carbon fluoride, etc. is optimally used as the deterioration suppressing gas supplied from gas source 86c. The amount of deterioration suppressing gas introduced into the vacuum container 84 is at a level where the effects of the coating forming gas can be canceled out based on the partial pressure of the coating forming gas and the reduction capability, oxidation capability, etc. of the deterioration suppressing gas. For example, in the case where the partial pressure of the coating forming gas was returned to the maximum allowable limit or less, formation of carbon film on the surface of the optical element would be considered to be stopped, so the introduction of deterioration suppressing gas would be continued until the partial pressure of the coating forming gas has returned to an appropriate normal level at or below the above maximum limit. Other techniques are also conceivable. In the case where the partial pressure of the deterioration suppressing gas had markedly dropped from the immediate partial pressure following introduction, it would be considered that the coating forming gas was consumed by the deterioration suppressing gas and carbon film was reduced. Specifically, it is also possible to continue introduction of deterioration suppressing gas until there is no longer a decrease in the partial pressure of the deterioration suppressing gas. It is possible to set the start of the introduction of the deterioration suppressing gas to an appropriate timing after the partial pressure of the coating forming gas has increased to at or above a previously set value, but, at this time, it is also possible to set a status in which the light source apparatus 50 operates to irradiate extreme ultraviolet rays to the respective optical elements that the illumination optical system 60 and the projection optical system 70 comprise. In this case, the extreme ultraviolet rays perform the role of promoting an oxidation-reduction reaction between the deterioration suppressing gas, and organic substance and the carbon film.

In a specific example, in the case where introduction was performed so that the partial pressure of a deterioration suppressing gas, which is a reducing gas, an oxidizing gas, etc., is in a range of a ratio of 1 × 10⁻² to 1 × 10⁸ with respect to the partial pressure of the coating forming gas of the organic substance, consumption, etc. of the coating forming gas was observed, and it was possible to avoid a decrease in the reflectivity of optical elements 54, 55, 63, 61, 62, 64, 71, 72, 73 and 74. The reaction equation below explains consumption of the coating forming gas and removal of the carbon film by the deterioration suppressing gas.
(Oxidation of hydrocarbons; by oxygen, ozone, nitrogen monoxide, and sulfur dioxide)

2CₙH₂ₙ₊₂+(3n+1)O₂→2nCO₂+(2n+2)H₂O

3CₙH₂ₙ₊₂+(3n+1)O₃→3nCO₂+(3n+3)H₂O

CₙH₂ₙ₊₂+2nNO→nCO₂+(n+1)H₂+nN₂

CₙH₂ₙ₊₂+n SO₂→nCO₂+nH₂S+H₂

(Reduction of hydrocarbons; by hydrogen)

CnH₂ₙ₊₂+(n-1)H₂→nCH₄

(Fluorination of hydrocarbons; by hydrogen fluoride and nitrogen fluoride)

CₙH₂ₙ₊₂+4nHF→nCF₄+(3n+1)H₂

3CₙH₂ₙ₊₂+4nNF₃→3nCF₄+2nN₂+(3n+3)H₂

(Oxidation of carbon film; by oxygen, ozone and nitrogen monoxide)

C+O₂→CO₂

3C+2O₃→3CO₂

C+2NO→CO₂+N₂

(Fluorination of carbon film; by hydrogen fluoride and nitrogen fluoride)

C+4HF→CF₄+2H₂

3C+4NF₃→3CF₄+2N₂

The illumination intensity sensor 88 is a photoelectric conversion element such as a photomultiplier arranged to be able to place and remove on the optical axis of the projection optical system 70, and it makes possible the measurement of the intensity of the exposure light by converting optical signals of the extreme ultraviolet rays, which are the exposure light that passes through the interior of the projection optical system 70 (specifically, reflected light from the mirror 74), into electrical signals. The illumination intensity sensor 88 is operated under the control of the control apparatus 90, and it outputs the detection results of the exposure light to the control apparatus 90 at an appropriate timing. Note that the illumination intensity sensor 88 is not limited to one which directly detects reflected light from mirror 74, etc., and it may also be one that detects scattered light from optical elements such as mirror 74 that the projection optical system 70 comprise, etc. In this case, the mechanism of the illumination intensity sensor 88 for placing and removing on the optical axis is not necessary, and the increase in detection strength shows a decrease in the reflectivity of the image light of the optical elements, that is, deterioration of the optical characteristics.

Here, in the case where the coating forming gas and oxidizing gas discussed above are present as the atmospheric gas of optical element 54, 55, 61, 62, 63, 64, 71, 72, 73, 74, etc., carbon film and oxidation film may be formed on the surface of the optical elements in the presence of extreme ultraviolet rays, and reflectivity may be decreased over time. For this reason, in the case where the illumination intensity of the exposure light is monitored based on the detection results of the illumination intensity sensor 88, and the illumination intensity has reached at a fixed lower limit, the mass flow controller 86e comprised by the gas supply apparatus 86 is regulated to introduce an appropriate amount of deterioration suppressing gas from the gas sources 86a, 86b, 86c to the vacuum container 84. The amount of deterioration suppressing gas introduced into the vacuum container 84 is at a level where the carbon film on the surfaces of the optical elements can be removed by oxidation-reduction, or the oxidation film on the surfaces of the optical elements can be removed by fluorination. Introduction of deterioration suppressing gas can be at an appropriate timing after the illumination intensity of the exposure light has been reduced to at or below a value that has been set in advance, but, in this case, it is also possible to set a status in which the light source apparatus 50 operates to irradiate extreme ultraviolet rays to the respective optical elements that the illumination optical system 60 and the projection optical system 70 comprise. In this case, the extreme ultraviolet rays play the role of promoting an oxidation-reduction reaction between the deterioration suppressing gas and the carbon film. In the case where, as a result of measurement by the illumination intensity sensor 88, the illumination intensity of the exposure light has returned to a previously set value or more, the control apparatus 90 operates the exhaust apparatus 85 to exhaust the deterioration suppressing gas in the vacuum container 84 to the exterior and to stop the progress of the oxidation-reduction reaction and the fluorination reaction.

In a specific example, in the case where introduction was performed so that the partial pressure of the deterioration suppressing gas, which is a reducing gas, an oxidizing gas or a fluorinating gas, comes to a range of a ratio of 1 × 10⁻² ~ 1 × 10⁸ with respect to the partial pressure of the coating forming gas of the organic substance, it was possible to restore the reflectivity of optical elements 54, 55, 61, 62, 63, 64, 71, 72, 73 and 74.

The overall operation of the exposure apparatus shown in FIG. 1 will be explained below. In this exposure apparatus, a mask MA is illuminated by illumination light from an illumination optical system 60, and the pattern image of the mask MA is projected onto a wafer WA by means of a projection optical system 70. As a result, the pattern image of the mask MA is transferred onto the wafer WA. At this time, the partial pressure of the deterioration causing gas, which is an oxidizing gas or a coating forming gas, is monitored by a mass spectrometry apparatus 87, and a deterioration suppressing gas is appropriately introduced into a vacuum container 84 from a gas supply apparatus 86 under the control of the control apparatus 90, so it is possible to maintain good optical characteristics of the optical elements that the projection optical system 70, etc. comprise for a long period of time. In addition, decreases in the reflectivity of the optical elements that the projection optical system 70, etc. comprise are monitored by an illumination intensity sensor 88, and the deterioration suppressing gas from the gas supply apparatus 86 is appropriately introduced into the vacuum container 84 under the control of the control apparatus 90. Through this as well, it is possible to maintain good optical characteristics of the optical elements that the projection optical system 70, etc. comprise for a long period of time.

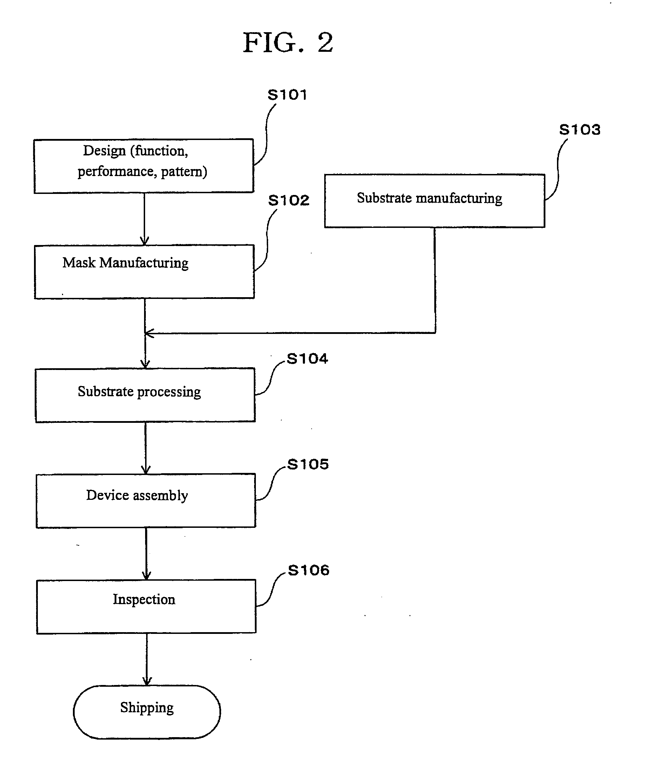

In the above, the explanation was for an exposure apparatus 10 and an exposure method using the same, but it is possible to provide a device manufacturing method for manufacturing semiconductor devices and other microdevices with high integration by using such an exposure apparatus 10. Specifically, as shown in FIG. 2, microdevices are manufactured by going through a step of performing design, etc. of microdevice functions and performance (S101), a step of manufacturing a mask MA based on this design step (S102), a step of preparing a substrate, that is, a wafer WA, which is the base material of the device (S103), an exposure processing step of exposing pattern of the mask MA on the wafer WA by the exposure apparatus 10 of the embodiment discussed above (S 104), a device assembly step of completing the element while repeating a series of exposures, etchings, etc. (S 1 05) and a device inspection step following assembly (S106). Note that a dicing step, a bonding step, a packaging step, etc. are normally included in the device assembly step (S105).

The present invention was explained according to the above embodiment, but the present invention is not limited to the above embodiment. For example, in the above embodiment, an explanation was given with respect to an exposure apparatus that uses extreme ultraviolet rays as the exposure light, but it is also possible to incorporate the gas supply apparatus 86, mass spectrometry apparatus 87, and illumination intensity sensor 88, etc. discussed above in an exposure apparatus that uses ultraviolet rays as the exposure light. In this case as well, it is possible to effectively prevent deterioration of optical characteristics including decreases in reflectivity and decreases in transmittivity of reflection type or transmission type optical elements that the exposure apparatus comprises, due to oxidation and carbon deposition by controlling the operation of the gas supply apparatus 86, the mass spectrometry apparatus 87 and the illumination intensity sensor 88, etc. by means of a control apparatus 90.

In addition, in the above embodiments, the corresponding deterioration suppressing gas is introduced into the vacuum container 84 by individually determining the results of monitoring the oxidation deterioration gas, the results of monitoring the coating forming gas, and the results of monitoring the illumination intensity of the exposure light, but it is also possible to review all of the results of monitoring the oxidation deterioration gas, the results of monitoring the coating forming gas, and the results of monitoring the illumination intensity of the exposure light to determine which of the reducing gas or oxidizing gas to introduce into the vacuum container 84 and to introduce these gases into the vacuum container 84 until effects become apparent.

In addition, it is possible to form a reflecting film, etc. consisting of a single layer metal film, etc. in place of a multilayer film on optical elements 54, 55, 61, 62, 63, 64, 71, 72, 73, and 74 and on the mask MA.

In addition, in the above embodiment, an apparatus that uses extreme ultraviolet rays as the exposure light was explained, but it is also possible to incorporate optical elements 54, 55, 61, 62, 63, 64, 71, 72, 73, and 74 and a mask MA, such as those shown in FIG. 1, etc., into a projection exposure apparatus that uses ultraviolet rays other than extreme ultraviolet rays as the exposure light, and it is possible to control deterioration of the reflection characteristics of the optical elements resulting from carbon deposition, etc. by means of the same type of atmospheric control as the above.

## Claims

1. An exposure apparatus control method comprising
a step of monitoring an observation element that reflects at least one of causes and indications of deterioration relating to an optical system of the exposure apparatus and
a step of introducing a deterioration suppressing gas that includes at least one of a reducing gas, an oxidizing gas and a fluorinating gas, into a container according to the results of monitoring the observation element.

2. An exposure apparatus control method according to Claim 1; **characterized in that**
the observation element is the partial pressure of a deterioration causing gas that includes at least one of oxygen, water and an organic substance in the container that accommodates the optical system, and
the deterioration suppressing gas is introduced into the container according to the results of monitoring the deterioration causing gas so that the partial pressure of the deterioration suppressing gas comes to have a ratio in a prescribed range with respect to the partial pressure of the deterioration causing gas in the container.

3. An exposure apparatus control method according to Claim 2; **characterized in that** the deterioration causing gas is an oxidation deterioration gas that includes at least one of oxygen and water, and the deterioration suppressing gas is an oxidation inhibiting gas that includes at least one of a reducing gas and a fluorinating gas.

4. An exposure apparatus control method according to Claim 3; **characterized in that**
the ratio in a prescribed range relating to the oxidation inhibiting gas as the deterioration suppressing gas is from 1 × 10⁻⁷ to 1 × 10⁴.

5. An exposure apparatus control method according to Claim 2; **characterized in that**
the deterioration causing gas is a coating forming gas that includes an organic substance, and the deterioration suppressing gas is a coating removing gas that includes at least one of a reducing gas, an oxidizing gas and a fluorinating gas.

6. An exposure apparatus control method according to Claim 5; **characterized in that**
the ratio in the prescribed range relating to the coating removing gas as the deterioration suppressing gas is from 1 × 10⁻² to 1 × 10⁸.

7. An exposure apparatus control method according to Claim 1; **characterized in that**
the observation element is the spectral characteristics of at least one optical element that the optical system of an exposure apparatus comprises,
and the deterioration suppressing gas is introduced into a container that accommodates the at least one optical element according to the results of monitoring the spectral characteristics of the at least one optical element.

8. An exposure apparatus control method according to any one of Claims 1 through 7; **characterized in that**
the optical system accommodated in the container is used in at least one wavelength range from among ultraviolet rays and extreme ultraviolet rays.

9. An exposure method for forming a mask pattern image on a substrate;
comprising a step of monitoring an observation element that reflects at least one of causes and indications of deterioration relating to an optical system for exposure and
a step of introducing into the container a deterioration suppressing gas that includes at least one of a reducing gas, an oxidizing gas and a fluorinating gas according to the results of monitoring the observation element.

10. An exposure method according to Claim 9; **characterized in that**
the observation element is a partial pressure of a deterioration causing gas that includes at least one of oxygen, water and an organic substance in a container that accommodates the optical system,
and the deterioration suppressing gas is introduced into the container according to the results of monitoring the deterioration causing gas so that the partial pressure of the deterioration suppressing gas comes to have a ratio in a prescribed range with respect to the partial pressure of the deterioration causing gas in the container.

11. An exposure method according to Claim 9; **characterized in that**
the observation element is the spectral characteristics of at least one optical element that the optical system comprises,
and the deterioration suppressing gas is introduced into a container that accommodates at least one optical element according to the results of monitoring the spectral characteristics of the at least one optical element.

12. An exposure apparatus comprising
a light source that generates light source light in a wavelength range of at least one of ultraviolet rays and extreme ultraviolet rays,
an illumination optical system that guides light source light from the light source to a mask for transfer,
a projection optical system that forms a pattern image of the mask on a substrate,
a sensor that monitors an observation element that reflects at least one of causes and indications of deterioration relating to an optical system that includes the projection optical system,
a gas introduction apparatus that introduces a deterioration suppressing gas that includes at least one of a reducing gas, an oxidizing gas and a fluorinating gas according to the monitoring results,
and a control apparatus that controls the operation of the gas introduction apparatus according to the monitoring results.

13. An exposure apparatus comprising
a light source that generates light source light in a wavelength range of at least one of ultraviolet rays and extreme ultraviolet rays,
an illumination optical system that guides light source light from the light source to a mask for transfer,
a projection optical system that forms the pattern image of the mask on a substrate,
a sensor that monitors a partial pressure of a deterioration causing gas that includes at least one of oxygen, water, and an organic substance in a container that accommodates at least some optical elements from among the illumination optical system, the projection optical system and the mask,
a gas introduction apparatus that introduces a deterioration suppressing gas that includes at least one of a reducing gas, an oxidizing gas and a fluorinating gas into the container,
and a control apparatus that sets the partial pressure of the deterioration suppressing gas to a ratio in a prescribed range with respect to the partial pressure of the deterioration causing gas in the container by controlling the operation of the gas introduction apparatus according to the results of monitoring the deterioration causing gas.

14. An exposure apparatus according to Claim 13; **characterized in that**
the deterioration causing gas is an oxidation deterioration gas that includes at least one of oxygen and water,
and the deterioration suppressing gas is an oxidation inhibiting gas that includes at least one of a reducing gas and a fluorinating gas.

15. An exposure apparatus according to Claim 13; **characterized in that**
the deterioration causing gas is a coating forming gas that includes an organic substance, and the deterioration suppressing gas is a coating removing gas that includes at least one of a reducing gas, an oxidizing gas and a fluorinating gas.

16. An exposure apparatus comprising
a light source that generates light source light in a wavelength range of at least one of ultraviolet rays and extreme ultraviolet rays,
an illumination optical system that guides light source light from the light source to a mask for transfer,
a projection optical system that forms the pattern image of the mask on a substrate,
a sensor that monitors the spectral characteristics of at least one optical element from among at least some optical elements that are accommodated in the container and that the mask, the illumination optical system and projection optical system comprise,
a gas introduction apparatus that introduces a deterioration suppressing gas that includes at least one of a reducing gas, an oxidizing gas and a fluorinating gas into the container,
and a control apparatus that controls the operation of the gas introduction apparatus according to the results of monitoring the spectral characteristics of the at least one optical element.

17. A device manufacturing method that uses an exposure apparatus according to any one of Claim 12 through Claim 16.
